# EUROPÄISCHE PATENTANMELDUNG

(11) **EP 4 507 473 A1**
(43) Veröffentlichungstag der Anmeldung: **12.02.2025**
(21) Anmeldenummer: 24185860.4
(22) Anmeldetag: 02.07.2024
(51) Int. Cl.: H10F 10/142, H10F 77/30, H10F 77/20

(54) **STAPELFÖRMIGE III-V MEHRFACHSOLARZELLE**

(30) Priorität: 11.07.2023 DE 102023002829
(71) Anmelder: AZUR SPACE Solar Power GmbH, 74072 Heilbronn (DE)
(72) Erfinder: Dr. Köstler, Wolfgang, 74074 Heilbronn (DE); Dr. Hagedorn, Benjamin, 74360 Ilsfeld (DE)
(74) Vertreter: Koch Müller Patentanwaltsgesellschaft mbH

(57) **Zusammenfassung**

Stapelförmige III-V Mehrfachsolarzelle mit einer Oberseite und eine Unterseite, aufweisend ein an der Oberseite der Mehrfachsolarzelle ausgebildeten metallischen Oberseitenkontaktbereich eine erste Metallschicht umfassend, ein an der Unterseite der Mehrfachsolarzelle flächig ausgebildeten metallischen Unterseitenkontaktbereich, eine sich von der Oberseite bis hin zu der Unterseite durchgehend erstreckende Öffnung, die Öffnung einen an der Oberseite ausgebildeten oberen Randbereich und einen an der Unterseite ausgebildeten unteren Randbereich aufweist, wobei der obere Randbereich an den Oberseitenkontaktbereich angrenzt und die Seitenwand und die beiden Randbereiche mit einer dielektrischen Schicht bedeckt sind, wobei die dielektrische Schicht eine Oberseite und eine Unterseite aufweist, wobei auf einer Oberfläche der ersten Metallschicht eine erste metallische Deckschicht ausgebildet ist und auf der Oberseite der dielektrischen Schicht und auf einen an den oberen Randbereich angrenzenden Teil der ersten Metallschicht eine zweite metallische Deckschicht ausgebildet ist.

## Beschreibung

Aus der US 9,680,035 B1 ist eine Solarzellenkontaktanordnung mit einem Solarzellenstapel umfassend mehrere III-V-Teilzellen auf einem GaAs-Substrat mit rückseitenkontaktierter Vorderseite bekannt. Hierbei wird ein von der Oberseite der Solarzelle durch die Teilzellen bis in eine noch nicht gedünnte Substratschicht hineinreichendes Loch mittels eines nasschemischen Ätzprozesses erzeugt. Eine Passivierung und Metallisierung der Vorderseite und des Lochs wird vor dem Dünnen der Substratschicht durchgeführt.

Vor diesem Hintergrund besteht die Aufgabe der Erfindung darin, eine Vorrichtung anzugeben, die den Stand der Technik weiterbildet.

Die Aufgabe wird durch eine stapelförmige III-V Mehrfachsolarzelle mit den Merkmalen des Patentanspruchs 1 gelöst. Vorteilhafte Ausgestaltungen der Erfindung sind Gegenstand von Unteransprüchen.

Gemäß dem Gegenstand wird eine stapelförmige III-V Mehrfachsolarzelle bereitgestellt, wobei die III-V Mehrfachsolarzelle eine Oberseite und eine Unterseite aufweist.

An der Unterseite ist eine Substratschicht ausgebildet. Oberhalb der Substratschicht ist eine erste Solarzelle mit einer ersten Bandlücke angeordnet.

Oberhalb der ersten Solarzelle ist eine zweite Solarzelle mit einer zweiten Bandlücke angeordnet, wobei die zweite Bandlücke größer als die erste Bandlücke ausgebildet ist.

Zwischen der ersten Solarzelle und der zweiten Solarzelle ist eine Tunneldiode ausgebildet.

Die Mehrfachsolarzelle umfasst an der Oberseite einen metallischen Oberseitenkontaktbereich mit einer ersten Metallschicht.

Um das Substrat elektrisch anzuschließen, ist an der Unterseite der Mehrfachsolarzelle ein flächig ausgebildeter metallischer Unterseitenkontaktbereich vorgesehen, wobei mittels des Oberseitenkontaktbereichs und des Unterseitenkontaktbereichs die Mehrfachsolarzelle elektrisch angeschlossen ist.

Von der Oberseite bis hin zu der Unterseite erstreckt sich eine durchgehende ovale Öffnung.

Die ovale Öffnung weist eine umlaufende Seitenwand und einen an der Oberseite ausgebildeten oberen Randbereich und einen an der Unterseite ausgebildeten unteren Randbereich auf, wobei der obere Randbereich an den Oberseitenkontaktbereich angrenzt.

Es sei angemerkt, dass die ovale Öffnung einen Durchmesser in einem Bereich zwischen 10 µm und 300 µm oder in einem Bereich zwischen 50 µm um 150 µm aufweist.

In einer Weiterbildung die ovale Öffnung auch exakt kreisförmig ausgebildet ist, d.h. einen konstanten Radius aufweist.

Die Seitenwand und die beiden Randbereiche sind mit einer dielektrischen Schicht vollständig bedeckt, wobei die dielektrische Schicht eine Oberseite und eine Unterseite aufweist.

In einer Ausführungsform umfasst die dielektrische Schicht eine Siliziumoxid insbesondere ein Siliziumdioxid und oder eine Siliziumnitrid. Alternativ besteht die dielektrische Schicht aus Siliziumoxid insbesondere aus Siliziumdioxid und oder aus Siliziumnitrid. In einer Weiterbildung liegt die Dicke der dielektrischen Schicht in einem Bereich zwischen 5 nm und 500 nm oder in einem Bereich zwischen 50 nm und 200 nm.

Es versteht sich, dass die dielektrische Schicht mittels eines Abscheideverfahrens aufgebracht wird. Insbesondere mittels eines CVD oder ALD Verfahrens.

Ferner bildet die dielektrische Schicht im Bereich der Seitenwand und in dem oberen Randbereich und dem unteren Randbereich eine stoffschlüssige Verbindung mit einem Halbleitermaterial aus.

Auf einer Oberfläche der ersten Metallschicht ist eine erste metallische Deckschicht ausgebildet, wobei die erste metallische Deckschicht eine Dicke in einem Bereich zwischen 5 nm und 300 nm, oder eine Dicke in einem Bereich zwischen 10 nm und 200 nm oder eine Dicke in einem Bereich zwischen 20 nm und 100 nm aufweist.

Auf der Oberseite der dielektrischen Schicht und auf einen an den oberen Randbereich angrenzenden Teil der ersten Metallschicht ist eine zweite metallische Deckschicht ausgebildet, wobei die zweite metallische Deckschicht eine Dicke in einem Bereich zwischen 10 nm und 100 nm, oder eine Dicke in einem Bereich zwischen 20 nm und 50 nm aufweist.

Auf der zweiten metallischen Deckschicht ist in dem an den oberen Randbereich angrenzenden Teil und dem oberen Randbereich und in dem an den oberen Randbereich angrenzenden Bereich der Seitenwand eine zweite Metallschicht angeordnet.

Die zweite Metallschicht bildet jeweils eine stoffschlüssige Verbindung mit der zweiten metallischen Deckschicht aus. Hierbei umfasst die metallische Deckschicht Titan oder eine Titanverbindung und / oder umfasst Nickel oder eine Nickelverbindung. In einer Weiterbildung besteht die metallische Abdeckschicht aus Titan oder einer Titanverbindung und / oder aus Nickel oder aus einer Nickelverbindung.

Des Weiteren sei angemerkt, dass die jeweiligen Metallschichten als Leiterbahnen ausgebildet sind, wobei die Metallschichten in einer Weiterbildung sowohl eine fingerförmige als auch eine flächige Ausbildung aufweisen.

Vorzugsweise werden die III-V Solarzellen in dem Bereich der extraterrestrischen Anwendungen eingesetzt. Insbesondere bei den extraterrestrischen Anwendungen ist eine zuverlässige elektrische Kontaktierung besonders wichtig.

Ein Vorteil ist, dass sich mittels der metallischen Deckschichten sich die Metallschichten an den Oberflächen gut passivieren lassen. Hierbei weisen die metallischen Deckschichten kein Gold oder Silber und auch keine Gold- und / oder Silberverbindungen auf. In dem die metallischen Deckschichten Titan oder Nickel oder Verbindungen aus Titan und / oder Nickel aufweisen lassen sich unterschiedliche Metallschichten zuverlässig und haltbar aufeinander ausbilden. Es versteht sich hierbei, dass sich die zweite Metallschicht nicht unmittelbar nach der ersten Metallschicht ausbilden lässt.

In einer Weiterbildung ist weist die III-V Mehrfachsolarzelle eine Dicke in einem Bereich zwischen 50 µm und 600 µm oder in einem Bereich zwischen 100 µm und 250 µm auf.

In einer Ausführungsform ist zwischen der zweiten metallischen Deckschicht und der dielektrischen Schicht eine schichtförmige Verbindung aus Titan und Sauerstoff und / oder Stickstoff ausgebildet. Nachfolgend wird die schichtförmige Verbindung auch als Haftschicht bezeichnet. Ein Vorteil ist, dass mittels der Haftschicht sich die Zuverlässigkeit der Verbindung erhöht und eine Abplatzen oder Reißen der zweiten metallischen Deckschicht verbessert wird.

In einer Weiterbildung liegt die Dicke der metallischen Deckschicht jeweils in einem Bereich zwischen 2 nm und 30 nm, oder in einem Bereich zwischen 3 nm und 10 nm oder in einem Bereich zwischen 4 nm und 7 nm.

In einer Weiterbildung ist eine dritte metallische Deckschicht auf einer Oberfläche der zweiten Metallschicht ausgebildet.

In einer Weiterbildung ist eine vierte metallische Deckschicht auf dem unteren Randbereich und auf dem an den unteren Randbereich angrenzenden Bereich der Seitenwand und einem auf der Seitenwand ausgebildeten Teil der zweiten Metallschicht ausgebildet. Die vierte metallische Deckschicht verbessert neben der Passivierung und Schutz der zweiten Metallschicht insbesondere die Haftung bei einer Aufbringung einer dritten Metallschicht auf der zweiten Metallschicht. Anders ausgedrückt, bei der Aufbringung der dritten Metallschicht lässt sind mittels der Anordnung der vierten Deckschicht eine zuverlässige und niederohmige Verbindung zwischen zwei Metallschichten ausbilden.

In einer Weiterbildung ist auf der vierten metallischen Deckschicht eine dritte Metallschicht ausgebildet, wobei die dritte Metallschicht sich durchgehend von dem unteren Randbereich und dem an den unteren Randbereich angrenzenden Teil der Seitenwand bis auf den mit der vierten metallischen Deckschicht abgedeckten Teil der zweiten Metallschicht erstreckt. Hierbei bildet die dritte Metallschicht mit der jeweiligen Unterlage eine stoffschlüssige Verbindung aus.

In einer Ausführungsform ist der untere Randbereich von dem Unterseitenkontaktbereich beabstandet.

In einer anderen Ausführungsform ist in dem unteren Randbereich mit der dritten Metallschicht eine Kontaktierungsfläche ausgebildet. Anders ausgedrückt, die dritte Metallschicht ist zumindest teilweise als Kontaktschicht zum elektrischen Anschluss der III-V Mehrfachzelle ausgebildet.

In einer Weiterbildung weist der Unterseitenkontaktbereich eine vierte Metallschicht auf. In einer Ausführungsform ist werden die dritte Metallschicht und die vierte Metallschicht in einem gemeinsamen Prozessschritt oder unterschiedlichen Prozessschritten ausgebildet.

In einer anderen Weiterbildung an einer Oberfläche der vierten Metallschicht eine weitere metallische Deckschicht ausgebildet ist. Ein Vorteil ist, dass sich die mittels der weiteren metallischen Deckschicht die Zuverlässigkeit der Kontaktierung erhöht.

In einer anderen Ausführungsform ist der Oberseitenkontaktbereich mittels der zweiten Metallschicht und der dritten Metallschicht mit der Kontaktierungsfläche auf der Unterseite elektrisch verbunden. Anders ausgedrückt, die Vorderseite der III-V Mehrfachsolarzelle lässt sich von der Rückseite kontaktieren d.h. elektrisch anschließen. Hiermit vereinfacht sich die elektrische Kontaktierung der III-V Mehrfachsolarzelle.

In einer Weiterbildung ist die Seitenwand vollständig umlaufend mit der zweiten Metallschicht und der dritten Metallschicht bedeckt. Hierbei sei angemerkt, dass um eine vollständige Bedeckung der Seitenwand zu erreichen beide Metallschichten notwendig sind.

In einer anderen Weiterbildung weist die Öffnung nach dem Aufbringen der Metallschichten eine lichte Weite auf.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: eine Ansicht auf eine stapelförmige III-V Mehrfachsolarzelle mit einer Durchgangsöffnung,
- Figur 2: eine Ansicht auf eine Weiterbildung der in der Figur 1 dargestellten Ausführungsform,
- Figur 3: eine Ansicht auf eine Weiterbildung der in der Figur 2 dargestellten Ausführungsform.

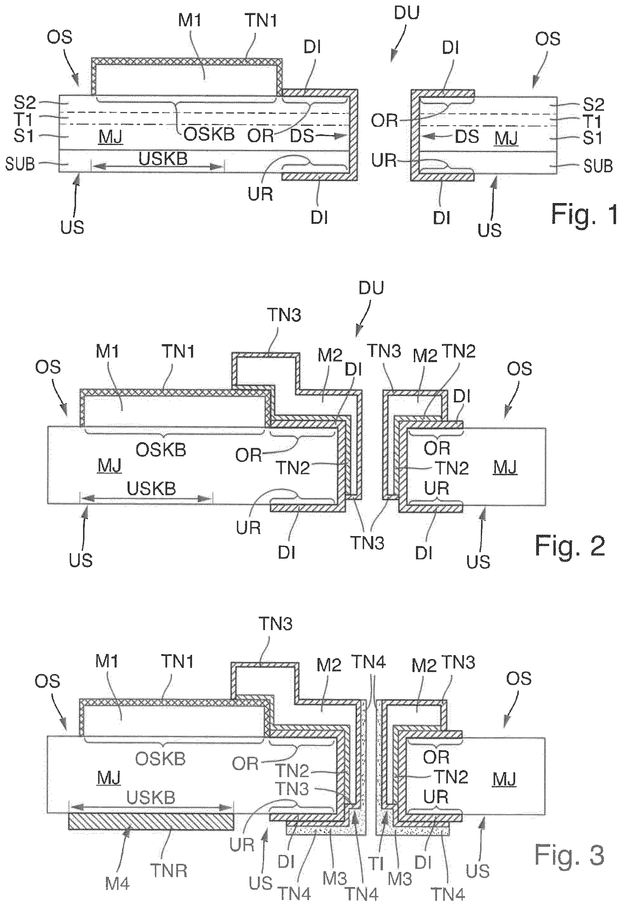

Die Abbildung der Figur 1 zeigt eine Ansicht einer Ausführungsform, aufweisend eine stapelförmige III-V Mehrfachsolarzelle MJ mit einer Oberseite OS und einer Unterseite US.

Die stapelförmige III-V Mehrfachsolarzelle MJ umfasst eine an der Unterseite US ausgebildete Substratschicht SUB mit einer oberhalb der Substratschicht SUB angeordneten ersten Solarzelle S1 mit einer ersten Bandlücke und eine oberhalb der ersten Solarzelle S1 angeordneten zweiten Solarzelle S2 mit einer zweiten Bandlücke, wobei die zweite Bandlücke größer als die erste Bandlücke ausgebildet ist.

Zwischen der ersten Solarzelle S1 und der zweiten Solarzelle S2 ist eine Tunneldiode T1 ausgebildet.

An der Oberseite der Mehrfachsolarzelle MJ ist ein metallischer Oberseitenkontaktbereich OSKB ausgebildet, wobei der Oberseitenkontaktbereich OSKB eine erste Metallschicht M1 umfasst.

Um das Substrat SUB elektrisch anzuschließen, ist an der Unterseite US der Mehrfachsolarzelle MJ ein flächig ausgebildeter metallischer Unterseitenkontaktbereich USKB angeordnet.

Mittels des Oberseitenkontaktbereichs OSKB und des Unterseitenkontaktbereichs USKB wird die Mehrfachsolarzelle MJ elektrisch angeschlossen.

Von der Oberseite OS erstreckt sich bis hin zu der Unterseite US eine durchgehend ovale Öffnung DU.

Die Öffnung DU weist eine umlaufende Seitenwand DS und einen an der Oberseite OS ausgebildeten oberen Randbereich OR und einen an der Unterseite US ausgebildeten unteren Randbereich UR auf.

Hierbei grenzt der obere Randbereich OR an den Oberseitenkontaktbereich OSKB an.

Ferner sind die Seitenwand DS und die beiden Randbereiche OR, UR mit einer dielektrischen Schicht DI vollständig bedeckt, wobei die dielektrische Schicht DI eine Oberseite und eine Unterseite aufweist.

Des Weiteren bildet die dielektrische Schicht DI an der Unterseite im Bereich der Seitenwand DI eine stoffschlüssige Verbindung mit einem Halbleitermaterial aus.

Auf einer Oberfläche der ersten Metallschicht M1 ist eine erste metallische Deckschicht TN1 ausgebildet, wobei die erste metallische Deckschicht TN1 eine Dicke in einem Bereich zwischen 5 nm und 300 nm, aufweist,
In der Abbildung der Figur 2 ist eine Weiterbildung der Ausführungsform der Figur 1 dargestellt. In Folgenden werden nur die Unterschiede erläutert.

Auf der Oberseite der dielektrischen Schicht DI und auf einen an den oberen Randbereich OR angrenzenden Teil der ersten Metallschicht M1 ist eine zweite metallische Deckschicht TN2 ausgebildet.

Die zweite metallische Deckschicht TN2 weist vorzugsweise eine Dicke in einem Bereich zwischen 10 nm und 100 nm auf.

Auf der zweiten metallischen Deckschicht TN2 ist auf dem an den oberen Randbereich OR angrenzenden Teil und dem oberen Randbereich OR und in dem an den oberen Randbereich OR angrenzenden Bereich der Seitenwand DS eine zweite Metallschicht M2 angeordnet.

Die zweite Metallschicht M2 bildet jeweils eine stoffschlüssige Verbindung mit der zweiten metallischen Deckschicht TN2 aus.

Zwischen der zweiten metallische Deckschicht TN2 und der dielektrischen Schicht DI ist eine Verbindung aus Titan und Sauerstoff ausgebildet. Es versteht sich, dass die Verbindung schichtförmig ausgebildet ist.

In der Abbildung der Figur 3 ist eine weitere Ausführungsform dargestellt. Nachfolgend werden nur die Unterschiede zu der Ausführungsform der Figur 2 erläutert.

Auf der Oberfläche der zweiten Metallschicht M2 ist eine dritte metallische Deckschicht TN3 ausgebildet.

Des Weiteren ist eine vierte metallische Deckschicht TN4 auf dem unteren Randbereich UR und auf dem an den unteren Randbereich UR angrenzenden Bereich der Seitenwand DS und einem auf der Seitenwand DS ausgebildeten Teil der zweiten Metallschicht M2 ausgebildet ist.

Auf der vierten metallischen Deckschicht TN4 eine dritte Metallschicht M3 ausgebildet ist und die dritte Metallschicht M3 sich durchgehend von dem unteren Randbereich UR und dem an den unteren Randbereich UR angrenzenden Teil der Seitenwand DS bis auf den mit der vierten metallische Deckschicht TN4 abgedeckten Teil der zweiten Metallschicht M2 erstreckt.

Ferner bildet die dritte Metallschicht M3 jeweils eine stoffschlüssige Verbindung mit der Unterlage aus.

Der untere Rand-bereich UR ist von dem Unterseitenkontaktbereich USKB beabstandet.

In dem unteren Randbereich UR ist mit der dritten Metallschicht M3 eine Kontaktierungsfläche ausgebildet.

Der Unterseitenkontaktbereich USKB eine vierte Metallschicht M4 aufweist und an einer Oberfläche der vierten Metallschicht M4 eine weitere metallische Deckschicht TNR ausgebildet ist.

Außerdem ist der Oberseitenkontaktbereich OSKB mittels der zweiten Metallschicht M2 und der dritten Metallschicht M3 mit der Kontaktierungsfläche auf der Unterseite US elektrisch verbunden.

Ferner ist die Seitenwand DS umlaufend vollständig mit der zweiten Metallschicht M2 und der dritten Metallschicht M3 bedeckt.

Des Weiteren weist die Öffnung DU nach dem Aufbringen der Metallschichten M1- M4 eine lichte Weite auf.

## Patentansprüche

1. Stapelförmige III-V Mehrfachsolarzelle (MJ) mit einer Oberseite (OS) und einer Unterseite (US), aufweisend
- eine an der Unterseite (US) ausgebildete Substratschicht (SUB),
- eine oberhalb der Substratschicht (SUB) angeordnete ersten Solarzelle (S1) mit einer ersten Bandlücke,
- eine oberhalb der ersten Solarzelle (S1) angeordneten zweiten Solarzelle (S2) mit einer zweiten Bandlücke, wobei die zweite Bandlücke größer als die erste Bandlücke ausgebildet ist,
- eine zwischen der ersten Solarzelle (S1) und der zweiten Solarzelle (S2) ausgebildete Tunneldiode (T1),
- ein an der Oberseite der Mehrfachsolarzelle (MJ) ausgebildeten metallischen Oberseitenkontaktbereich (OSKB), wobei der Oberseitenkontaktbereich (OSKB) eine erste Metallschicht (M1) umfasst,
- ein, um das Substrat (SUB) elektrisch anzuschließen, an der Unterseite (US) der Mehrfachsolarzelle (MJ) flächig ausgebildeten metallischen Unterseitenkontaktbereich (USKB), wobei mittels des Oberseitenkontaktbereichs (OSKB) und des Unterseitenkontaktbereichs (USKB) die Mehrfachsolarzelle (MJ) elektrisch angeschlossen ist,
- eine sich von der Oberseite (OS) bis hin zu der Unterseite (US) durchgehend erstreckende ovale Öffnung (DU),
- die Öffnung (DU) eine umlaufende Seitenwand (DS) und einen an der Oberseite (OS) ausgebildeten oberen Randbereich (OR) und einen an der Unterseite (US) ausgebildeten unteren Randbereich (UR) aufweist, wobei der obere Randbereich (OR) an den Oberseitenkontaktbereich (OSKB) angrenzt,
- die Seitenwand (DS) und die beiden Randbereiche (OR, UR) mit einer dielektrischen Schicht (DI) vollständig bedeckt sind, wobei die dielektrische Schicht (DI) eine Oberseite und eine Unterseite aufweist und die dielektrische Schicht (DI) an der Unterseite (US) im Bereich der Seitenwand (DI) eine stoffschlüssige Verbindung mit einem Halbleitermaterial ausbildet,
- auf einer Oberfläche der ersten Metallschicht (M1) eine erste metallische Deckschicht (TN1) ausgebildet ist und die erste metallische Deckschicht (TN1) eine Dicke in einem Bereich zwischen 5 nm und 300 nm, aufweist,
- auf der Oberseite der dielektrischen Schicht (DI) und auf einen an den oberen Randbereich (OR) angrenzenden Teil der ersten Metallschicht (M1) eine zweite metallische Deckschicht (TN2) ausgebildet ist, wobei die zweite metallische Deckschicht (TN2) eine Dicke in einem Bereich zwischen 10 nm und 100 nm, aufweist,
- auf der zweiten metallischen Deckschicht (TN2) in dem an den oberen Randbereich (OR) angrenzenden Teil und dem oberen Randbereich (OR) und in dem an den oberen Randbereich (OR) angrenzenden Bereich der Seitenwand (DS) eine zweite Metallschicht (M2) angeordnet ist und die zweite Metallschicht (M2) jeweils eine stoffschlüssige Verbindung mit der zweiten metallischen Deckschicht (TN2) ausbildet.

2. Stapelförmige III-V Mehrfachsolarzelle (MJ) nach Anspruch 1, **dadurch gekennzeichnet, dass** zwischen der zweiten metallische Deckschicht (TN2) und der dielektrischen Schicht (Di) eine schichtförmige Verbindung aus Titan und Sauerstoff und / oder Stickstoff ausgebildet ist.

3. Stapelförmige III-V Mehrfachsolarzelle (MJ) nach Anspruch 1 oder Anspruch 2, **dadurch gekennzeichnet, dass** eine dritte metallische Deckschicht (TN3) auf einer Oberfläche der zweiten Metallschicht (M2) ausgebildet ist.

4. Stapelförmige III-V Mehrfachsolarzelle (MJ) nach einem der vorangegangenen Ansprüche, **dadurch gekennzeichnet, dass** eine vierte metallische Deckschicht (TN4) auf dem unteren Randbereich (UR) und auf dem an den unteren Randbereich (UR) angrenzenden Bereich der Seitenwand (DS) und einem auf der Seitenwand (DS) ausgebildeten Teil der zweiten Metallschicht (M2) ausgebildet ist.

5. Stapelförmige III-V Mehrfachsolarzelle (MJ) nach Anspruch 4, **dadurch gekennzeichnet, dass** auf der vierten metallischen Deckschicht (TN4) eine dritte Metallschicht (M3) ausgebildet ist und die dritte Metallschicht (M3) sich durchgehend von dem unteren Randbereich (UR) und dem an den unteren Randbereich (UR) angrenzenden Teil der Seitenwand (DS) bis auf den mit der vierten metallischen Deckschicht (TN4) abgedeckten Teil der zweiten Metallschicht (M2) erstreckt und die dritte Metallschicht (M3) eine stoffschlüssige Verbindung mit der jeweiligen Unterlage ausbildet.

6. Stapelförmige III-V Mehrfachsolarzelle (MJ) nach einem der vorangegangenen Ansprüche, **dadurch gekennzeichnet, dass** der untere Rand-bereich (UR) von dem Unterseitenkontaktbereich (USKB) beabstandet ist.

7. Stapelförmige III-V Mehrfachsolarzelle (MJ) nach einem der vorangegangenen Ansprüche, **dadurch gekennzeichnet, dass** in dem unteren Randbereich (UR) mit der dritten Metallschicht (M3) eine Kontaktierungsfläche ausgebildet ist.

8. Stapelförmige III-V Mehrfachsolarzelle (MJ) nach einem der vorangegangenen Ansprüche, **dadurch gekennzeichnet, dass** der Unterseitenkontaktbereich (USKB) eine vierte Metallschicht (M4) aufweist und an einer Oberfläche der vierten Metallschicht (M4) eine weitere metallische Deckschicht (TNR) ausgebildet ist.

9. Stapelförmige III-V Mehrfachsolarzelle (MJ) nach einem Ansprüche 5 - 7, **dadurch gekennzeichnet, dass** der Oberseitenkontaktbereich (OSKB) mittels der zweiten Metallschicht (M2) und der dritten Metallschicht (M3) mit der Kontaktierungsfläche auf der Unterseite (US) elektrisch verbunden ist.

10. Stapelförmige III-V Mehrfachsolarzelle (MJ) nach einem der vorangegangene Ansprüche, **dadurch gekennzeichnet, dass** die Seitenwand (DS) umlaufend vollständig mit der zweiten Metallschicht (M2) und der dritten Metallschicht (M3) bedeckt.

11. Stapelförmige III-V Mehrfachsolarzelle (MJ) nach einem der vorangegangene Ansprüche, **dadurch gekennzeichnet, dass** die Öffnung (DU) nach dem Aufbringen der Metallschichten (M1- M4) eine lichte Weite aufweist.

12. Stapelförmige III-V Mehrfachsolarzelle (MJ) nach einem der vorangegangene Ansprüche, **dadurch gekennzeichnet, dass** die metallische Deckschichten (TN1-TN4, TNR) als Titanschicht oder als Nickelschicht ausgebildet ist oder zumindest Titan und / oder Nickel umfassen.
